# DEMANDE DE BREVET EUROPEEN

(11) **EP 2 685 499 A1**
(43) Date de publication de la demande: **15.01.2014**
(21) Numéro de dépôt: 13175434.3
(22) Date de dépôt: 05.07.2013
(51) Int. Cl.: H01L 27/12, H01L 27/02, H01L 29/786

(54) **Circuit integre sur soi comprenant un triac de protection contre des decharges electrostatiques**

(30) Priorité: 13.07.2012 FR 1256801
(71) Demandeur: Commissariat à l'Énergie Atomique et aux Énergies Alternatives, 75015 Paris (FR); STmicroelectronics SA, 92120 Montrouge (FR)
(72) Inventeur: Fenouillet-Beranger, Claire, 38000 GRENOBLE (FR); Fonteneau, Pascal, 38570 THEYS (FR)
(74) Mandataire: Guérin, Jean-Philippe

(57) **Abrégé**

L'invention concerne un circuit intégré (9), comprenant :
-des premier à quatrième composants électroniques (1, 2) ;
-une couche isolante enterrée (92) de type UTBOX ;
-des premier à quatrième plans de masse (11, 21) à l'aplomb des premier, deuxième, troisième et quatrième composants électroniques ;
-une première tranchée d'isolation (62) isolant les premier à quatrième plans de masse ;
-des premier à quatrième caissons (12, 22) à l'aplomb et en contact avec les premier à quatrième plans de masse ;
-des première à quatrième électrodes (14, 24) de polarisation en contact avec les premier à quatrième caissons et avec les premier à quatrième plans de masse ;
-un substrat semi-conducteur (91) ;
-un caisson profondément enterré (51) en contact avec les caissons et les séparant du substrat ;
-une électrode de commande (GN) couplée au caisson profondément enterré.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour « Fully Depleted Silicium On Insulator » en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT (pour « Low V_{T} » en langue anglaise, typiquement 400mV), de transistors à haute tension de seuil dits HVT (pour « High V_{T} » en langue anglaise, typiquement 550mV) et de transistors à tension de seuil moyenne dits SVT (pour « Standard V_{T} » en langue anglaise, typiquement 450mV) ou RVT (pour « Regular V_{T} » en langue anglaise).

Pour permettre le fonctionnement des différents transistors, il est nécessaire de les isoler électriquement les uns des autres. Par conséquent, les transistors sont généralement entourés par des tranchées d'isolation (désignées par l'acronyme STI pour « Shallow Trench Isolation » en langue anglaise) qui s'étendent jusqu'aux caissons.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

De l'état de la technique est connu des documents suivants :
- US 2009/134468 A1 ;
- US 2007/063284 A1 ;
- WO 2010/112585 A1 ;
- J.P. Noël et al., « Multi-VT UTBB FDSOI Device Architectures for Low-Power CMOS Circuit » ; IEEE Transactions on Electron Devices, vol. 58, p. 2473-2482, 1er août 2011 ;
- J.P. Noël et al., « UT2B-FDSOI device architecture dedicated to low power design techniques » ; Proceedings of IEEE ESSDERC 2010.
- WO 2011/089179 A1.

Il existe un besoin pour une protection contre les décharges électrostatiques ne nuisant pas à la compacité du circuit intégré, capable d'évacuer une décharge localisée quelle que soit sa polarité, et peu coûteux.

L'invention porte ainsi sur un circuit intégré tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus schématique d'une portion de circuit intégré au niveau de plans de masse ;
- la figure 2 est une vue en coupe du circuit au niveau d'une première cellule ;
- la figure 3 est un schéma électrique équivalent d'un circuit de protection inférieur de la première cellule ;
- la figure 4 est une vue en coupe du circuit au niveau d'une deuxième cellule ;
- la figure 5 est un schéma électrique équivalent d'un circuit de protection inférieur de la deuxième cellule ;
- la figure 6 illustre le schéma électrique équivalent aux circuits de protections des cellules ;
- la figure 7 est une représentation schématique d'un exemple de dispositif de protection intégré à l'aplomb d'une cellule à protéger.

L'invention propose d'utiliser, dans un circuit intégré, des tranchées d'isolation de profondeur et de dimensions réduites afin de réaliser des dispositifs de protection ESD d'un circuit intégré. De tels dispositifs de protection, ménagés sous les composants électroniques, ne nuisent pas à la densité d'intégration du circuit et permettent d'assurer une protection localisée et quelle que soit la polarité de la décharge électrostatique.

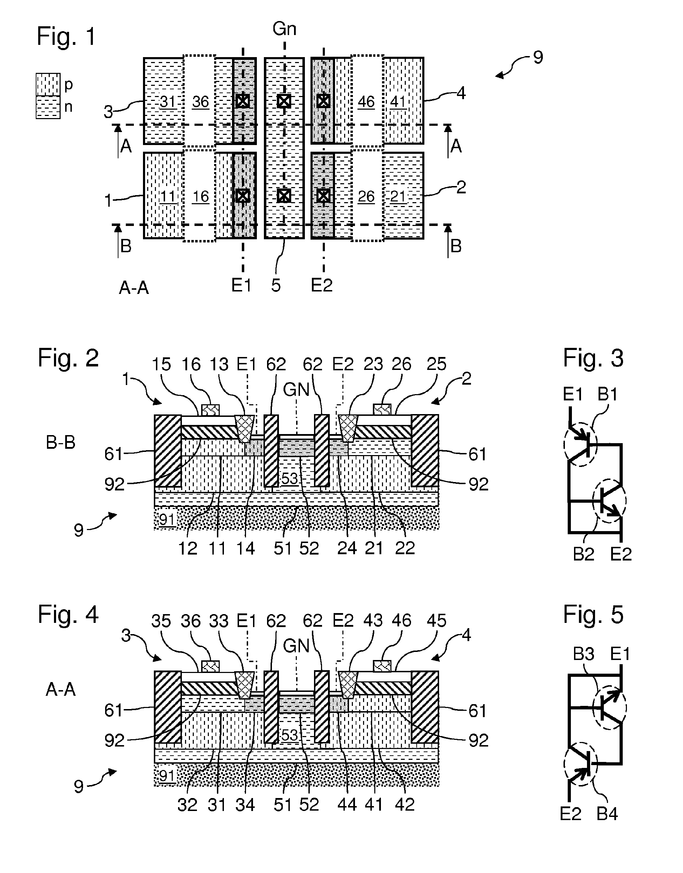

La figure 1 est une vue de dessus schématique d'une portion d'un circuit intégré 9 fabriqué sur SOI. Le circuit intégré 9 comporte ici une première cellule comprenant des composants électroniques 1 et 2, et une deuxième cellule comprenant des composants électroniques 3 et 4. Les figures 2 et 4 sont des vues en coupe transversales respectives des première et deuxième cellules. Les composants électroniques 1 à 4 sont réalisés dans une couche d'un matériau semi-conducteur, dite couche active, formée sur une couche isolante 92, cette couche isolante 92 étant formée à l'aplomb d'un substrat semi-conducteur 91 à dopage de type p.

Les composants électroniques 1 à 4 sont en l'occurrence des transistors à effet de champ de type FDSOI. Les composants 1 à 4 peuvent également être des FED (pour « Field Effect Diode » en langue anglaise), des FER (pour « Field Effect rectifier » en langue anglaise), ou des Z²-FET.

Les transistors 1 et 3 sont par exemple des transistors nMOS et les transistors 2 et 4 sont par exemple des transistors pMOS. Les transistors sont généralement alignés dans une rangée de cellules incluant chacune un transistor nMOS et un transistor pMOS. Les transistors nMOS des différentes cellules sont alors alignés.

Les transistors 1 à 4 comportent de façon connue en soi une source, un drain et un canal, et un empilement de grille réalisé à l'aplomb du canal. La source, le drain et le canal des transistors 1 à 4 sont ménagés respectivement dans des couches actives semi-conductrices 15, 25, 35 et 45. Les transistors 1 à 4 comportent des empilements de grille respectifs 16, 26, 36 et 46 disposés respectivement sur les couches actives semi-conductrices 15, 25, 35 et 45, à l'aplomb du canal. Pour simplifier les dessins, la structure détaillée des couches actives n'y est pas représentée. Les transistors de la couche active peuvent comporter de façon connue en soi un canal en matériau semi-conducteur faiblement dopé, avec une concentration de dopants sensiblement égale à la concentration de dopants du substrat 91. Les transistors 1 à 4 comportent également des électrodes de source et de drain respectives, non illustrées.

Des plans de masse 11, 21, 31 et 41 semi-conducteurs sont formés respectivement à l'aplomb des transistors 1 à 4, sous la couche isolante enterrée 92. Le dopage du plan de masse 11 est de type p, celui du plan de masse 21 est de type n, celui du plan de masse 31 est de type n, et celui du plan de masse 41 est de type p.

Les plans de masse 11, 21, 31 et 41 sont polarisés respectivement via des implants 14, 24, 34 et 44 semi-conducteurs. Les implants 14, 24, 34 et 44 présentent des dopages respectifs de type p, n, n et p (et de préférence des dopages P+, N+, N+ et P+ respectivement). La polarisation des plans de masse peut être effectuée par l'intermédiaire d'un circuit de commande non représenté ici. Les implants 14, 24, 34 et 44 sont coplanaires aux plans de masse 11, 21, 31 et 41. Par coplanaire, on entend que l'on peut définir un plan parallèle à la couche 92 et traversant les zones concernées.

Des caissons 12, 22, 32 et 42 semi-conducteurs sont formés respectivement, à l'aplomb des plans de masse 11, 21, 31 et 41. Le dopage des caissons 12, 22, 32 et 42 est de type p.

Un caisson 51 profondément enterré et à dopage de type n forme une séparation entre les caissons 12, 22, 32 et 42 et le substrat 91 à dopage de type p.

La couche isolante enterrée 92isole électriquement les transistors 1 à 4 de leur plan de masse, de leur caisson, et du substrat 91.

La couche isolante enterrée 92 formée à l'aplomb des transistors est ici de type UTBOX (« Ultra-Thin Buried Oxide Layer » en langue anglaise). Ainsi, le contrôle de la polarisation des plans de masse 11, 21, 31 et 41 permet de moduler les tensions de seuil respectives des transistors 1 à 4. La couche isolante 92 présente par exemple une épaisseur inférieure ou égale à 60nm, inférieure ou égale à 50nm, voir inférieure ou égale à 20nm. La couche isolante 92 peut être réalisée de façon connue en soi en oxyde de silicium.

Des tranchées d'isolation profondes 61 et 62 sont ménagées à la périphérie de chacun des transistors 1 à 4. Les tranchées d'isolation 61 et 62 s'étendent en profondeur au travers de la couche isolante 92, jusque dans les caissons respectifs 12, 22, 32 et 42 pour les transistors 1 à 4.

Les transistors 1 à 4 comportent en outre des tranchées d'isolation 13, 23, 33 et 43 respectivement. Les tranchées d'isolation 13, 23, 33 et 43 sont ménagées à l'aplomb du contact entre les plans de masse 11, 21, 31 et 41 et les implants 14, 24, 34 et 44 respectivement. Les tranchées d'isolation 13, 23, 33 et 43 sont moins profondes que les tranchées d'isolation 61 et 62. Les tranchées d'isolation 13, 23, 33 et 43 ne s'étendent pas jusqu'à leurs caissons 12, 22, 32 et 42 respectifs. Les tranchées d'isolation 13, 23, 33 et 43 traversent ici la couche isolante 92 et s'étendent donc jusque dans leurs plans de masse 11, 21, 31 et 41 respectifs. Les tranchées d'isolation 13, 23, 33 et 43 permettent d'améliorer l'isolation entre les transistors 1 à 4 et leurs implants 14, 24, 34 et 44.

Les implants 14, 24, 34 et 44 sont ici ménagés latéralement par rapport aux transistors 1 à 4. Les implants 14 et 34 sont polarisés à un premier niveau de tension E1. Les implants 24 et 44 sont polarisés à un deuxième niveau de tension E2, différent de E1. Un dispositif 5 de protection contre les décharges électrostatique est inclus dans le circuit intégré 9. La protection contre les décharges électrostatiques vise à assurer une protection contre les décharges entre les niveaux de tension E1 et E2.

Le dispositif 5 de protection de protection contre les décharges électrostatiques comporte ici un implant 52. L'implant 52 est ici dopé de type n (dopage N+ en l'occurrence). L'implant 52 est ici coplanaire aux implants 14, 24, 34 et 44. L'implant 52 s'étend sur les première et deuxième cellules, entre les tranchées d'isolation 62.

Le dispositif 5 de protection comporte en outre un caisson 53 disposé à l'aplomb de l'implant 52. Le caisson 53 comporte le même type de dopage que l'implant 52, ici un dopage de type n. Le caisson 53 est ici coplanaire aux caissons 12, 22, 32 et 42. Le caisson 53 s'étend plus profondément que les tranchées d'isolation 62 et est en contact avec les caissons 12, 22, 32 et 42. Le caisson 53 s'étend jusqu'en contact avec le caisson profondément enterré 51. Un potentiel de commande GN peut être appliqué sur le caisson 53.

Dans la première cellule, le dispositif de protection 5 forme le schéma électrique équivalent illustré à la figure 3. Des transistors bipolaires B1 et B2 sont formés. Le transistor bipolaire B1 est un transistor pnp et le transistor B2 est un transistor npn.

Pour le transistor B1 :
- l'émetteur est formé par l'implant 14 et le caisson 12, et est au potentiel E1 ;
- la base est formée par l'implant 52, le caisson 53 et le caisson 51, et est au potentiel GN ;
- le collecteur est formé par le caisson 22, et est au potentiel E2.

Pour le transistor B2 :
- l'émetteur est formé par l'implant 24, et est au potentiel E2 ;
- la base est formée par le caisson 22, et est au potentiel E2 ;
- le collecteur est formé par l'implant 52, le caisson 53 et le caisson 51, et est au potentiel GN.

Dans la deuxième cellule, le dispositif de protection 5 forme le schéma électrique équivalent illustré à la figure 5. Des transistors bipolaires B3 et B4 sont formés. Le transistor bipolaire B3 est un transistor npn et le transistor B4 est un transistor pnp.

Pour le transistor B3 :
- l'émetteur est formé par l'implant 34, et est au potentiel E1 ;
- la base est formée par le caisson 32, et est au potentiel E1 ;
- le collecteur est formé par l'implant 52, le caisson 53 et le caisson 51, et est au potentiel GN.

Pour le transistor B4 :
- l'émetteur est formé par l'implant 44 et le caisson 42, et est au potentiel E2 ;
- la base est formée par l'implant 52, le caisson 53 et le caisson 51, et est au potentiel GN ;
- le collecteur est formé par le caisson 32, et est au potentiel E1.

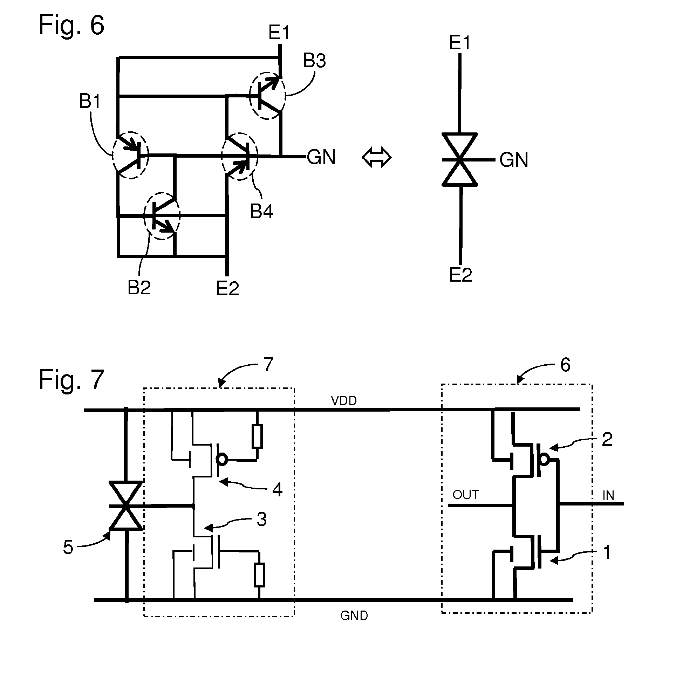

La figure 6 illustre un schéma électrique équivalent, qui montre que la combinaison des transistors B1 à B4 forme un triac. L'implant 52, le caisson 53 et le caisson 51 forment ainsi une gâchette du TRIAC formé dans le circuit intégré 9. La gâchette du TRIAC est ainsi contrôlée par le signal GN. Les implants 14, 24, 34 et 44 destinés à polariser les plans de masse 11, 21, 31 et 41 sont utilisés pour la formation du TRIAC. Un dispositif de protection 5 particulièrement simple et peu coûteux peut ainsi être formé.

Le TRIAC permet ainsi d'assurer une protection contre les décharges électrostatiques entre les potentiels E1 et E2, et ce quelle que soit la polarité de la décharge. Les potentiels E1 et E2 peuvent par exemple être respectivement des potentiels à Vdd et à la masse. Le TRIAC ainsi formé est logé essentiellement sous les transistors 1 à 4 et n'affecte donc que marginalement la densité d'intégration du circuit intégré.

Les caissons 12, 22, 32 et 42 peuvent présenter des concentrations de dopants comprises entre 10¹⁶cm⁻³ et 10¹⁸cm⁻³. Les plans de masse 11, 21, 31 et 41 peuvent présenter des concentrations de dopants comprises entre 10¹⁸cm⁻³ et 10¹⁹cm⁻³. Les caissons 12, 22, 32 et 42 peuvent s'étendre jusqu'à une profondeur inférieure à 1µm et, de préférence, inférieure ou égale à 700nm.

Des contacts métalliques peuvent être déposés directement sur chacun des implants 14, 24, 34, 44 et 52, afin de permettre une connexion électrique de chacun d'eux. Avantageusement, les implants 14, 24, 34, 44 et 52 présentent chacun une concentration de dopants au moins cinquante fois, ou cent fois supérieure à la concentration de dopants des caissons 12, 22, 32 et 42. Par exemple, les implants 14, 24, 34, 44 et 52 présentent des concentrations de dopants avantageusement supérieures ou égales à 5*10¹⁸cm⁻³ et, de préférence, comprises entre 10¹⁹cm⁻³ et 10²¹cm⁻³. Ces concentrations de dopants sont par exemple sensiblement égales aux concentrations de dopants de la source ou du drain des transistors 1 à 4.

Le signal GN peut être généré par un circuit de détection d'une décharge électrostatique, un tel circuit étant connu en soi. Le dispositif de protection 5 peut être destiné à protéger localement les première et deuxième cellules ménagées à l'aplomb, ou destiné à former une protection centralisée du circuit intégré 9.

La figure 7 illustre schématiquement un exemple dans lequel le dispositif de protection 5 assure une protection localisée de la première cellule. La première cellule est ici un inverseur logique 6 de type CMOS (« Complementary Metal Oxide Semiconductor » en langue anglaise). L'inverseur 6 présente une entrée IN, configurée pour recevoir un signal logique d'entrée et une sortie OUT, configurée pour retourner un signal logique correspondant à l'inverse logique du signal d'entrée. L'inverseur 6 peut notamment être utilisé comme interface d'entrée/sortie du circuit intégré 9. Le dispositif de protection 5 assure ici la protection contre les décharges électrostatiques entre un rail d'alimentation à Vdd et un rail d'alimentation à la tension de masse. Dans cet exemple,
- les grilles respectives des transistors 1 et 2 de la première cellule sont électriquement connectées entre elles et électriquement connectées à l'entrée IN,
- les drains respectifs des transistors 1 et 2 sont électriquement connectés entre eux et électriquement connectés à la sortie OUT, et
- les sources des transistors 1 et 2 sont, respectivement, électriquement polarisées et à une masse GND et à une tension d'alimentation VDD du circuit intégré 9 ;
- le substrat 91 est électriquement connecté à la masse GND.

La deuxième cellule forme un circuit de commande 7 du dispositif de protection 5. Le transistor nMOS 3 a sa grille connectée électriquement à la masse GND par l'intermédiaire d'une résistance. Le plan de masse 31 est connecté au potentiel de la grille du transistor 3. La source du transistor 3 est connectée à la masse GND. Le drain du transistor 3 est connecté à la gâchette du TRIAC du dispositif de protection 5. Le transistor pMOS 4 a sa grille connectée électriquement à la tension d'alimentation Vdd par l'intermédiaire d'une résistance. Le plan de masse 41 est connecté au potentiel de la grille du transistor 4. La source du transistor 4 est connectée à la tension Vdd. Le drain du transistor 4 est connecté à la gâchette du TRIAC. Lesdites résistances peuvent être par exemple fixées à une valeur souhaitée en jouant sur la profondeur des tranchées d'isolation 13, 23, 33, 43 en dessous de la couche isolante enterrée 92. Plus ces tranchées d'isolation 13, 23, 33, 43 sont profondes, plus la valeur de résistance entre grille et implant est élevée.

En fonction de la polarité d'une décharge électrostatique entre les rails d'alimentation à Vdd et à Gnd, soit le transistor 3, soit le transistor 4 est rendu passant, de façon à déclencher le TRIAC. Le TRIAC rendu passant, la décharge électrostatique entre les rails d'alimentation à Vdd et à Gnd traverse le TRIAC, la première cellule étant ainsi protégée contre cette décharge.

## Revendications

1. Circuit intégré (9), comprenant :
- des premier, deuxième, troisième et quatrième composants électroniques (1, 2) ;
- une couche isolante enterrée (92) de type UTBOX, disposée sous et à l'aplomb desdits composants électroniques ;
- des premier, deuxième, troisième et quatrième plans de masse (11, 21) ménagés à l'aplomb respectivement des premier, deuxième, troisième et quatrième composants électroniques sous la couche isolante enterrée (92), les premier et quatrième plans de masse présentant un premier type de dopage, les deuxième et troisième plans de masse présentant un second type de dopage opposé au premier ;
- au moins une première tranchée d'isolation (62) isolant les premier, deuxième, troisième et quatrième plans de masse entre eux ;
- des premier, deuxième, troisième et quatrième caissons (12, 22) respectivement ménagés à l'aplomb et en contact avec les premier, deuxième, troisième et quatrième plans de masse et présentant le premier type de dopage ;
- des première, deuxième, troisième et quatrième électrodes (14, 24) de polarisation en contact respectivement avec les premier, deuxième, troisième et quatrième caissons et avec les premier, deuxième, troisième et quatrième plans de masse, les première et troisième électrodes étant adaptées à être connectées à une première tension de polarisation et les deuxième et quatrième électrodes étant adaptées à être connectées à une deuxième tension de polarisation différente de la première tension ;
- un substrat semi-conducteur (91) présentant le premier type de dopage ;
- un caisson profondément enterré (51) présentant le deuxième type de dopage, en contact avec les premier, deuxième, troisième et quatrième caissons et les séparant du substrat ;
- une électrode de commande (GN) couplée au caisson profondément enterré.

2. Circuit intégré (9) selon la revendication 1, dans lequel les première, deuxième, troisième et quatrième électrodes (14, 24, 34, 44) de polarisation et les premier, deuxième, troisième et quatrième plans de masse (11, 21, 31, 41) sont coplanaires.

3. Circuit intégré (9) selon la revendication 2, comprenant en outre au moins des deuxièmes tranchées d'isolation (13, 23, 33, 43) s'étendant à l'aplomb des contacts respectifs entre les premier, deuxième, troisième et quatrième plans de masse (11, 21, 31, 41) et les première, deuxième, troisième et quatrième électrodes (14, 24, 34, 44) de polarisation.

4. Circuit intégré (9) selon la revendication 3, dans lequel les deuxièmes tranchées d'isolation (13, 23, 33, 43) s'étendent au travers de la couche isolante enterrée (92), jusque dans un desdits plans de masse et jusqu'à une profondeur strictement inférieure à l'interface entre lesdits plans de masse et lesdits caissons.

5. Circuit intégré (9) selon l'une quelconque des revendications précédentes, dans lequel les premier, deuxième, troisième et quatrième composants électroniques (1, 2, 3, 4) sont des transistors de type FDSOI.

6. Circuit intégré (9) selon la revendication 5, dans lequel les premier et troisième composants électroniques sont des transistors nMOS et dans lequel les deuxième et quatrième composants électroniques sont des transistors pMOS.

7. Circuit intégré (9) selon la revendication 6, dans lequel les premier et deuxième composants électroniques (1, 2) sont couplés pour former un inverseur logique (6) formant une interface d'entrée/sortie du circuit intégré.

8. Circuit intégré selon la revendication 7, dans lequel les premier et deuxième plans de masse (11, 21) sont couplés aux sources respectives des transistors des premier et deuxième composants électroniques.

9. Circuit intégré (9) selon l'une quelconque des revendications précédentes, incluant en outre un dispositif de détection d'une décharge électrostatique (7) configuré pour détecter une décharge électrostatique et appliquer un signal de commande sur l'électrode de commande (GN) lors de la détection d'une décharge.

10. Circuit intégré selon la revendication 9, dans lequel les troisième et quatrième composants (3, 4) sont inclus dans ledit dispositif de détection de décharge électrostatique (7).

11. Circuit intégré selon la revendication 9 ou 10, dans lequel les premier et troisième composants électroniques et les deuxième et quatrième composants électroniques sont disposés de part et d'autre de l'électrode de commande (GN), l'électrode de commande étant isolée des premier, deuxième, troisième et quatrième plans de masse et isolée des première, deuxième, troisième et quatrième électrodes par l'intermédiaire de la première tranchée d'isolation (62).

12. Circuit intégré (9) selon l'une quelconque des revendications précédentes, dans lequel les première et deuxième tensions de polarisation incluent une tension de masse électrique (GND) et une tension d'alimentation (VDD) du circuit intégré.

13. Circuit intégré (9) selon l'une quelconque des revendications précédentes, dans lequel lesdites première, deuxième, troisième et quatrième électrodes de polarisation incluent un implant semi-conducteur présentant une concentration de dopants au moins cinquante fois supérieure à la concentration de dopants dans les premier, deuxième, troisième et quatrième caissons.

14. Circuit intégré (9) selon l'une quelconque des revendications précédentes, dans lequel le premier type de dopage est de type P.
